Europäisches Patentamt

European Patent Office

Office européen des brevets

(19)

(11) **EP 0 632 589 B1**

(12)

# FASCICULE DE BREVET EUROPEEN

(45) Date de publication et mention
de la délivrance du brevet:
**16.12.1998 Bulletin 1998/51**

(51) Int Cl.⁶: **H03H 21/00**, H03H 17/06

(21) Numéro de dépôt: **94401487.7**

(22) Date de dépôt: **30.06.1994**

(54) **Procédé de calcul de coefficients de pondération pour un numériseur analytique pour traitement de signal, et numériseur analytique**

Verfahren zur Berechnung von Wiegekoeffizienten eines analytischen Digitalisiergerätes für Signalverarbeitung und analytisches Digitalisiergerät

Method of calculating the weighting coefficients for an analytic digitizer for signal processing and analytic digitizer

(84) Etats contractants désignés:
**DE FR GB IT**

(30) Priorité: **01.07.1993 FR 9308067**

(43) Date de publication de la demande:
**04.01.1995 Bulletin 1995/01**

(73) Titulaire: **ALCATEL ALSTHOM Compagnie Générale d'Electricité**
**75008 Paris (FR)**

(72) Inventeur: **Marguinaud, André**
**F-91120 Palaiseau (FR)**

(74) Mandataire: **Sciaux, Edmond**
**COMPAGNIE FINANCIERE ALCATEL**
**Dépt. Propr. Industrielle,**
**30, avenue Kléber**
**75116 Paris (FR)**

(56) Documents cités:
**US-A- 4 843 581**

## Description

L'invention concerne un procédé pour calculer des coefficients de pondération utilisés dans un numériseur analytique pour traitement de signal. Dans le domaine des télécommunications et de la détection, il est connu de traiter un signal réel après l'avoir numérisé analytiquement, c'est-à-dire l'avoir représenté par une suite d'échantillons complexes. Les échantillons complexes peuvent être représentés sous une forme cartésienne (x, y), ou sous une forme polaire (r, Θ), dont le pas temporel ne dépend que de la largeur de bande du signal représenté. La forme cartésienne est plus avantageuse pour réaliser des filtrages fréquentiels, alors que la forme polaire est plus avantageuse pour réaliser des translations de fréquence et des estimations de phase ou de fréquence.

Un numériseur analytique de type connu, réalisé au moyen de composants analogiques, comporte deux voies comportant chacune un modulateur, un filtre, un amplificateur, et un échantillonneur. Un oscillateur fournit deux signaux sinusoïdaux en quadrature, respectivement aux deux modulateurs qui reçoivent par ailleurs le signal à traiter. En général, la fréquence de cet oscillateur est commandable de façon à compenser la dérive de sa fréquence ou bien pour obtenir un signal en bande de base. Ce type de numériseur nécessite la réalisation de deux voies qui soient aussi parfaitement identiques que possible, en ce qui concerne les caractéristiques du filtre, le gain, et les caractéristiques de l'échantillonneur et du convertisseur analogique-numérique. Cet équilibrage des deux voies est difficile à mettre au point et nécessite de nombreux composants.

Pour éviter ce problème d'équilibrage de deux voies, d'autres types de numériseur analytique déterminent les valeurs des deux composantes en quadrature au moyen d'un seul échantillonneur et d'un seul convertisseur analogique-numérique, suivis de deux voies numériques qui réalisent des traitements différents. Il n'y a plus de problème d'équilibrage puisque les deux composantes peuvent être déterminées à partir d'une même série de valeurs d'échantillon. L'article : Digital Processing for Positioning With One Satellite by A. Marguinaud, published by Advisory Group for Aerospace Research and Development, 7 rue Ancelle 92200 Neuilly sur Seine, France, décrit un numériseur analytique dans lequel les deux voies numériques sont constituées par deux filtres à réponse impulsionnelle finie. Ce numériseur met en oeuvre un procédé qui repose sur la représentation uniforme de tout signal continu par une somme de fonctions trigonométriques, conformément au théorème de Weierstrass: La composante réelle x(t) et la composante en quadrature y(t) de tout signal réel continu peuvent être représentées au moyen de formules de la forme :

$$x\bigl(t\bigr)= \sum_{j=0}^{n} A_j.\cos\bigl(j\varpi t+\phi j\bigr)$$

$$(1)$$

$$y\bigl(t\bigr)= \sum_{j=0}^{n} B_j.\sin\bigl(j\varpi t+\phi j\bigr)$$

où n ne dépend que de l'écart toléré, entre le signal réel et son approximation.

Dans le cas de signaux à bande limitée, le théorème d'échantillonnage permet de remplacer les pulsations $j\omega$ par leur valeur modulo $\frac{1}{4\pi\Delta t}$, en désignant par $\Delta t$ le pas temporel d'échantillonnage. Il en résulte que les seules composantes à prendre en compte dans les considérations théoriques appartiennent à la bande physique. En pratique, il en est ainsi chaque fois que l'échantillonneur est précédé par un filtre passe-bande.

Cet article enseigne que la réalisation d'un numériseur analytique est particulièrement simple dans le cas où les filtres ne prennent en compte que quatre échantillons et où la fréquence centrale du signal à traiter est égale à un quart de la fréquence d'échantillonnage. Il donne des valeurs de coefficients $a_0$, $a_1$, $b_0$, $b_1$. Les deux filtres calculent alors les deux composantes conformément aux formules suivantes :

$$(2) \begin{cases} x(t) =a_0\left[r\left(t+\dfrac{\Delta t}{2}\right)+r\left(t-\dfrac{\Delta t}{2}\right)\right]+a_1\left[r\left(t+\dfrac{3\Delta t}{2}\right)+r\left(t-\dfrac{3\Delta t}{2}\right)\right] \\[2em] y(t) =b_0\left[r\left(t-\dfrac{\Delta t}{2}\right)-r\left(t+\dfrac{\Delta t}{2}\right)\right]+b_1\left[r\left(t-\dfrac{3\Delta t}{2}\right)-r\left(t+\dfrac{3\Delta t}{2}\right)\right] \end{cases}$$

Avec $a_0 = 3$      $a_1 = -1$

$b_0 = 3 \qquad b_1 = 1$

Cet article enseigne aussi que le bruit dû à la numérisation du signal et aux calculs effectués par les filtres, appelé bruit de quadrature, est tel que le rapport signal sur bruit est de 20dB lorsque la bande passante est égale à un quart de la fréquence centrale du signal, et de 30dB lorsque la largeur de bande du signal est égale à la moitié de la fréquence centrale de ce signal.

L'article Traitement Analytique du Signal par A. Marguinaud, publié par le Ministère de la Défense; Direction Générale de l'Armement Direction des Recherches, Etudes et Techniques; 4 rue de la Porte d'Issy, 75015 Paris; enseigne que la recherche des coefficients de pondération doit être limitée à des coefficients symétriques entre eux ,$a_0$, ..., $a_h$, $a_h$, ..., $a_0$; pour une première composante du signal ; et anti-symétrique entre eux $b_0$, ..., $b_h$, - $b_h$, ..., $-b_0$ pour la seconde composante.

Cet article suggère aussi de déterminer des coefficients qui soient adaptés au spectre du signal à traiter.

Un procédé heuristique, réalisant une simulation dans un ordinateur permet de déterminer des coefficients de pondération pour quatre, voire six échantillons, mais un procédé heuristique ne donne pas des valeurs de coefficients ayant une précision suffisante lorsque le nombre d'échantillons est supérieur à six.

Le but de l'invention est de proposer un procédé de calcul des coefficients pour un numériseur analytique comportant deux filtres à réponse impulsionnelle finie, prenant en compte plus de quatre échantillons, en les pondérant par des coefficients déterminés selon un procédé général rigoureux, de façon à pouvoir optimiser le rapport signal sur bruit de quadrature et la complexité de réalisation du numériseur, pour chaque application, c'est-à-dire en fonction du spectre du signal reçu et du rapport signal sur bruit de quadrature qui est souhaitable pour cette application.

Un autre but de l'invention est de proposer un numériseur analytique dans lequel le nombre et la valeur des coefficients de pondération varient automatiquement en fonction des caractéristiques du signal reçu, pour des applications telles que les récepteurs de surveillance radioélectrique, pour lesquels les caractéristiques du signal reçu ne sont pas constantes.

Un premier objet de l'invention est un procédé de calcul de coefficients de pondération pour un numériseur analytique pour traitement de signal, ce numériseur comportant :

- des moyens pour échantillonner un signal analogique à traiter, et pour convertir la valeur analogique de chaque échantillon en une valeur numérique;
- des premiers moyens de calcul fournissant une suite de valeurs numériques x(t), chaque valeur étant calculée en additionnant 2h+2 valeurs fournies par les moyens pour numériser, après les avoir pondérées respectivement par des coefficients $a_0$, ..., $a_h$, $a_h$, ..., $a_0$, entiers, non nuls;
- des seconds moyens de calcul fournissant une suite de valeurs numériques y(t), chaque valeur étant calculée en additionnant 2h+2 valeurs fournies par les moyens pour numériser, après les avoir pondérées respectivement par des coefficients $b_0$, ..., $b_h$, $-b_h$, ...,$-b_0$ entiers non nuls;
- des moyens pour fournir aux premiers et aux seconds moyens de calcul les valeurs des coefficient $a_0$, ..., $a_h$, $b_0$, ..., $b_h$;

caractérisé en ce que, pour un numériseur calculant des couples de valeurs x(t), y(t) à un rythme fixé Fe, pour un signal ayant une fréquence centrale Fc et une largeur de bande B prédéterminées, et pour un nombre h prédéterminé, le calcul des coefficients $a_0$,..., $a_h$ et $b_0$,..., $b_h$ consiste à :

- remplacer les lignes trigométriques cos $(2i + 1)\theta$ et sin $(2i+1)\theta$ pour i = 0, ..., h, respectivement par des expressions polynomiales classiques, respectivement de la forme :

$$\begin{cases} \cos(2i+1)\theta = (-1)^i \left(\cos\theta\right).Q_i\left[\left(\cos\theta\right)^2\right] \\ \sin(2i+1)\theta = .\left(\sin\theta\right).Q_i\left[\left(\sin\theta\right)^2\right] \end{cases}$$

où $Q_i$ est un polynôme classique de degré i, dans les polynômes suivants :

$$\begin{cases} Gx = a_0 \cos\theta + a_1 \cos 3\theta + \ldots + a_i \cos(2i+1)\theta + \ldots + a_h \cos(2h+1)\theta \\ Gy = b_0 \sin\theta + b_1 \sin 3\theta + \ldots + b_i \sin(2i+1)\theta + \ldots + b_h \sin(2h+1)\theta \end{cases}$$

pour obtenir deux polynômes appelés gains relatifs des premiers et seconds moyens de calcul, et qui sont de la forme :

$$Gx = (\cos\theta) . \sum_{i=0}^{h} (-1)^i . a_i . Q_i \left[ (\cos\theta)^2 \right]$$

$$Gy = (\sin\theta) \sum_{i=0}^{h} . b_i . Q_i . \left[ (\sin\theta)^2 \right]$$

- puis annuler les h premières dérivées des deux gains relatifs $G_x$, $G_y$, respectivement autour de la valeur centrale $\cos\theta$ et autour de la valeur centrale $\sin\theta$, pour $\theta = \pi \dfrac{F_c}{F_e}$, en modifiant légèrement $F_c$ pour obtenir de bonnes approximations rationnelles;
- puis résoudre par un algorithme classique les deux systèmes de h équations linéaires à coefficients entiers, ainsi obtenu; la résolution de ce système fournissant des valeurs des coefficients $a_0$, ..., $a_{h-1}$, respectivement $b_0$, ..., $b_{h-1}$ en fonction de $a_0$, respectivement b0, sous forme rationnelle;
- multiplier par un même facteur entier tous les coefficients $a_1$,..., $a_h$, respectivement $b_1$, ..., $b_h$, pour les mettre sous une forme entière fonction de $a_0$, respectivement $b_0$;
- calculer la valeur de $a_0$, respectivement $b_0$, telle que les gains relatifs Gx et Gy soient approximativement égaux pour $\theta = \pi \dfrac{F_c}{F_e}$ , avec une précision donnée fonction de l'application du numériseur.

Le procédé ainsi caractérisé est un procédé général et rigoureux, les coefficients peuvent donc être parfaitement optimisés en fonction des caractéristiques d'un signal attendu.

L'invention a aussi pour objet un numériseur analytique caractérisé en ce que le nombre h+1 des coefficients $a_0$,..., $a_h$,, respectivement $b_0$,...,$b_h$, et leur valeur sont variables en fonction de la fréquence centrale $F_c$ et de la largeur de bande B du spectre le signal à traiter;

et en ce que les moyens pour fournir les valeurs des coefficients $a_0$, ..., $a_h$, $b_0$, ..., $b_h$, comportent :

- des moyens pour incrémenter le nombre h, en prenant initialement h=1, le nombre h pouvant être incrémenté ultérieurement sous la commande d'un signal d'incrémentation;
- des moyens pour remplacer les lignes trigonométriques $\cos(2i+1)\theta$ et $\sin(2i+1)\theta$ pour $i = 0, \ldots, h$ , respectivement par leurs expressions polynomiales classiques de la forme :

$$\begin{cases} \cos(2i+1)\theta = (-1)^i (\cos\theta) . Q_i \left[ (\cos\theta)^2 \right] \\ \sin(2i+1)\theta = (\sin\theta) . Q_i \left[ (\sin\theta)^2 \right] \end{cases}$$

où $Q_i$ est un polynôme classique de degré i, dans les polynomes suivants :

$$\begin{cases} G_x = a_0\cos\theta + a_1\cos 3\theta +\ldots + a_i\cos(2i+1)\theta +\ldots + a_h\cos(2h+1)\theta \\ G_y = b_0\sin\theta + b_1\sin 3\theta +\ldots + b_i\sin(2i+1)\theta +\ldots + b_h\sin(2h+1)\theta \end{cases}$$

pour obtenir deux polynômes appellés gains relatifs des premiers et seconds moyens de calcul, et qui sont de la forme :

$$Gx = \left(\cos\theta\right).\sum_{i=0}^{h}(-1)^i a_i . Q_i\left[\left(\cos\theta\right)^2\right]$$

$$Gy = \left(\sin\theta\right)\sum_{i=0}^{h} b_i . Q_i\left[(\sin\theta)^2\right]$$

- des moyens pour annuler les h premières dérivées des deux gains relatifs $G_x$, $G_y$ respectivement autour de la valeur $\cos\theta$ et autour de la valeur $\sin\theta$, pour la valeur $\theta = \pi\frac{Fc}{Fe}$ convenable;
- des moyens pour résoudre, par un algorithme classique, les 2 systèmes de h équations linéaires à coefficients entiers, ainsi obtenu; la résolution de ces systèmes fournissant des valeurs des coefficients $a_1,\ldots,a_h$, respective-ment $b_1,\ldots, b_h$, en fonction de $a_0$, respectivement $b_0$, sous forme rationnelle;
- des moyens pour multiplier par un même facteur entier les valeurs ainsi obtenues, pour tous les coefficients $a_1,\ldots,$ $a_h$, respectivement $b_1,\ldots,b_h$, pour les mettre sous une forme entière fonction de $a_0$, respectivement $b_0$;
- des moyens pour calculer une valeur de $a_0$, respectivement $b_0$, telles que les gains relatifs Gx, Gy soient approxi-mativement égaux pour $\theta = \pi\frac{F_c}{F_e}$;
- des moyens pour calculer une valeur estimée du rapport signal sur bruit de quadrature, égale à :

$$\frac{S}{N} = 4\left[\frac{G_y^2 + G_x^2}{G_y^2 - G_x^2}\right]^2$$

- des moyens pour comparer la valeur estimée de ce rapport à une valeur limite prédéterminée définissant le rapport signal sur bruit de quadrature minimal tolérable; ces moyens fournissant un signal d'incrémentation aux moyens pour incrémenter le nombre h, si la valeur du rapport est inférieure à la valeur limite, ou fournissant un signal de validation de la valeur courante de h et des valeurs de coefficient qui viennent d'être déterminées, si la valeur du rapport est supérieure ou égale à la valeur limite.

Le numériseur analytique ainsi caractérisé permet de traiter un signal ayant des caractéristiques variables, puisque le nombre et la valeur des coefficients de pondération varient en fonction de ces caractéristiques. Les performances de ce numériseur analytique peuvent être optimales pour chaque signal à traiter, puisqu'un dispositif de calcul peut redéterminer les valeurs des coefficients de pondération lorsque les caractéristiques du signal à traiter ont changées.

L'invention sera mieux comprise et d'autres caractéristiques apparaîtront à l'aide de la description ci-dessous d'un exemple de réalisation du numériseur analytique, selon l'invention :

- la figure 1 représente le schéma synoptique d'une partie de cet exemple de réalisation, déterminant un couple de valeurs x(t), y(t);
- la figure 2 représente le schéma synoptique d'une autre partie de cet exemple de réalisation, calculant le nombre h+1 et la valeur des coefficients $a_0$, ..., $a_h$, respectivement $b_0$, ..., $b_h$, en fonction des caractéristiques du signal à traiter;
- la figure 3 représente un schéma synoptique de l'ensemble de cet exemple de réalisation;
- et la figure 4 représente un graphe illustrant le fonctionnement d'une partie de cet exemple de réalisation.

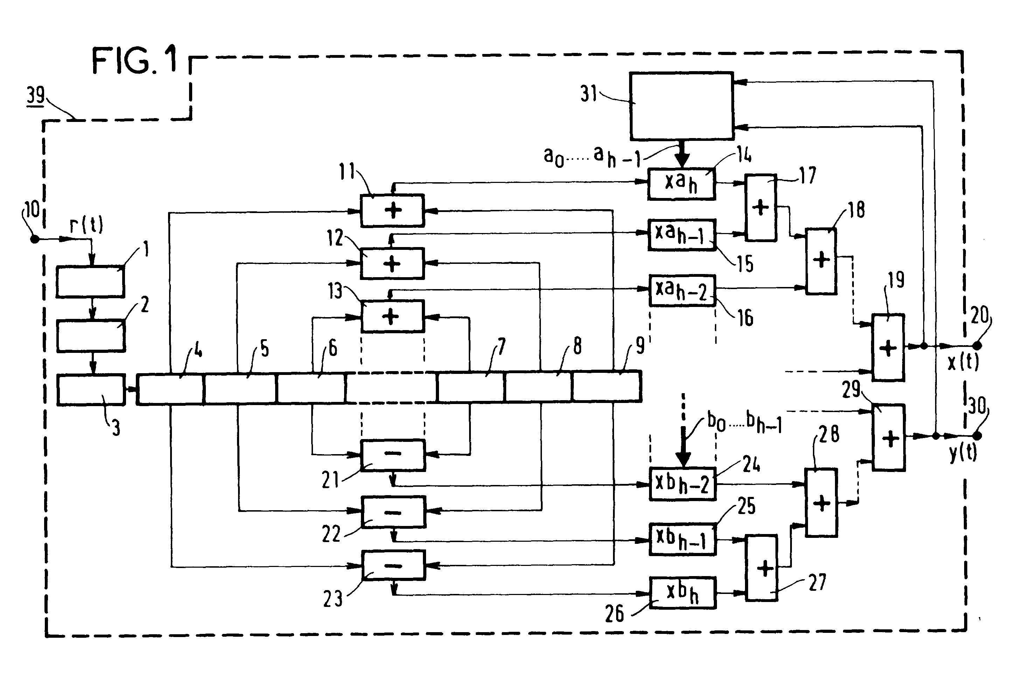

La première partie, 39, dont le schéma synoptique est représenté sur la figure 1, comporte : une borne d'entrée 10 recevant un signal analogique réel r(t); et deux bornes de sortie, 20 et 30, fournissant respectivement une première composante du signal et une seconde composante, en quadrature,

constituées respectivement d'une suite de valeurs x(t) et d'une suite de valeurs y(t) représentées chacune par un mot binaire. Cette première partie 39 calcule les valeurs de x(t) et y(t) conformément aux formules :

$$(3) \quad \begin{cases} x(t) = a_0\left[r\left(t+\frac{\Delta t}{2}\right)+r\left(t+-\frac{\Delta t}{2}\right)\right] + a_1\left[R\left(t+\frac{3\Delta t}{2}\right)+r\left(t-\frac{3\Delta t}{2}\right)\right] + \dots \\ \qquad\qquad + a_h\left[r\left(t+\frac{(2h+1)\Delta t}{2}\right)+r\left(t-\frac{(2h+1)\Delta t}{2}\right)\right] \\ y(t) = b_0\left[r\left(t-\frac{\Delta t}{2}\right)-r\left(t+\frac{\Delta t}{2}\right)\right] + b_1\left[r\left(t-\frac{3\Delta t}{2}\right)-r\left(t+\frac{3\Delta t}{2}\right)\right] + \dots \\ \qquad\qquad + b_n\left[r\left(t-\frac{(2h+1)\Delta t}{2}\right)-r\left(t+\frac{(2h+1)\Delta t}{2}\right)\right] \end{cases}$$

Des considérations théoriques permettent de démontrer que tout signal réel continu r(t) occupant une bande de fréquence de largeur B peut être représenté de façon uniforme par une suite d'échantillons complexes de valeur x(t), y(t) avec un pas temporel $\Delta t = \frac{1}{B}$, c'est-à-dire un rythme de calcul $F_e = B$, quelle que soit la fréquence centrale $F_c$ de ce signal réel. D'autre part, on démontre que la largeur de bande utilisable pour recevoir un signal est maximale si la fréquence centrale du signal reçu est égale à un quart de la fréquence d'échantillonnage de ce signal reçu. En pratique, le signal appliqué à la borne d'entrée 10 a déjà subi une translation de fréquence pour réaliser cette condition, s'il s'agit d'un signal à large bande qui nécessite de prendre cette précaution pour que sa largeur de bande n'excède pas la largeur de bande utilisable pour le numériseur analytique considéré.

La partie 39 représentée sur la figure 1 comporte :

- un filtre passe-bande 1 ayant une bande passante correspondant à la largeur de bande maximale du signal appliqué à la borne d'entrée 10;
- un échantillonneur-bloqueur 2;
- un convertisseur analogique-numérique 3;
- un registre à décalage comportant 2h+2 étages 4, 5, 6,..., 8, 9;
- une série d'additionneurs comportant (h+1) additionneurs, 11, 12, 13, ...;
- une série de soustracteurs comportant (h+1) soustracteurs, 21, 22, 23,...;
- une première série de multiplieurs comportant (h+1) multiplieurs 14, 15, 16, ...;
- une seconde série de multiplieurs comportant (h+1) multiplieurs, ..., 24, 25, 26;
- une deuxième série d'additionneurs comportant h additionneurs à deux entrées 17, ..., 19, reliés en cascade pour calculer la somme de (h+1) valeurs fournies respectivement par des sorties de la première série de multiplieurs 14, 15, 16, ..., la sortie de l'additionneur 19 étant reliée à la borne de sortie 20;
- une troisième série d'additionneurs à deux entrées, 27, 28, ..., 29; reliés en cascade pour faire la somme de h+1 valeurs fournies respectivement par des sorties de la seconde série de multiplieurs 24, 25, 26, ...; la sortie de l'additionneur 29 étant reliée à la borne de sortie 30 ;
- un dispositif de calcul 31 ayant deux entrées reliées respectivement aux sorties des additionneurs 19 et 29 et ayant une sortie multiple reliée respectivement à des entrées des deux séries de multiplieurs 14, 15, 16, ..., 24, 25, 26, pour leur fournir respectivement des valeurs de coefficient de pondération $a_0$, ..., $a_h$, $b_0$, ..., $b_h$.

La partie 39 calcule des couples de valeurs x(t), y(t) à un rythme Fe identique au rythme de l'échantillonnage et de la numérisation. Dans d'autres exemples de réalisation, la fréquence d'échantillonnage et de numérisation peut être égale à un multiple du rythme de calcul, Fe, de façon à laisser l'échantillonneur-bloqueur 2 et le convertisseur 3 travailler au rythme préconisé par leur fabricant pour un fonctionnement optimal.

Cet exemple de réalisation est conçu pour permettre une adaptation automatique du nombre et de la valeur des coefficients de pondération en fonction des caractéristiques du signal reçu, et du rapport signal sur bruit de quadrature qui est souhaité. Pour les applications où les caractéristiques du signal reçues sont constantes, ou à peu près constantes, un autre exemple de réalisation comportant un nombre fixé de coefficients, et une valeur fixée pour chaque coefficient, peut être déduit facilement de l'exemple de réalisation décrit ici.

Le schéma synoptique représenté sur la figure 1 est celui d'un exemple de réalisation constitué de composants discrets, afin d'illustrer les formules (3) utilisées pour calculer les valeurs des deux composantes du signal reçu. Cependant, un autre exemple de réalisation peut comporter un processeur convenablement programmé pour réaliser ce même calcul.

Dans l'exemple de réalisation représenté sur la figure 1, les étages 4, 5, 6, ..., 7, 8, 9 du registre à décalage mémorisent, à l'instant t, considéré, les valeurs d'échantillon suivantes :

$$r\left(t + \frac{(2h+1)\Delta t}{2}\right)$$

$$\cdots\cdots\cdots$$

$$r\left(t + \frac{(3\Delta t)}{2}\right)$$

$$r\left(t + \frac{\Delta t}{2}\right)$$

$$r\left(t - \frac{\Delta t}{2}\right)$$

$$r\left(t - \frac{(3\Delta t)}{2}\right)$$

$$\cdots\cdots\cdots$$

$$r\left(t - \frac{(2h+1)\Delta t}{2}\right)$$

où $\Delta t$ est la période d'échantillonnage et de la numérisation, qui est égale à $\frac{1}{Fe}$ dans cet exemple de réalisation.

L'additionneur 11 possède deux entrées reliées respectivement à deux sorties des étages 4 et 9. L'additionneur 12 possède deux entrées reliées respectivement à des sorties des étages 5 et 8. L'additionneur 13 possède deux entrées reliées respectivement à des sorties des étages 6 et 7. Chaque additionneur de la série 11, 12, 13, etc, fait la somme de deux valeurs d'échantillons disposés symétriquement par rapport à l'instant t, et réalise donc une sorte d'interpolation entre deux échantillons. Le résultat de chacune de ces interpolations est multiplié par un coefficient de pondération $a_h$, $a_{h-1}$, $a_{h-2}$, etc, au moyen des multiplieurs 14, 15, 16, ....La série d'additionneurs 17, 18, ..., 19 additionne le résultat de ces multiplications pour obtenir la valeur x(t) conformément aux formules (3).

Le soustracteur 23 possède deux entrées reliées respectivement à des sorties des étages 4 et 9. Le soustracteur 22 possède deux entrées reliées respectivement à des sorties des étages 5 et 8. Le soustracteur 21 possède deux entrées reliées respectivement à des sorties des étages 6 et 7. Chacun des soustracteurs 23, 22, 21, ..., calcule la différence entre deux échantillons situés symétriquement par rapport à l'instant t. Les valeurs de ces différences sont multipliées respectivement par les coefficients de pondération $b_h$, $b_{h-1}$, $b_{h-2}$, ..., $b_0$, au moyen des multiplieurs 26, 25, 24, ...Les résultats de ces multiplications sont additionnés par les additionneurs 27, 28, ..., 29 pour obtenir la valeur y(t).

Le dispositif 31 reçoit les valeurs x(t) et y(t) pour le calcul et l'optimisation des coefficients de pondération en fonction des changements de caratéristiques du signal reçu. Il détermine des valeurs entières pour les coefficients $a_0,\ldots, a_h, b_0,\ldots, b_h$, telles que les formules (3) fournissent un couple de valeur x(t), y(t) représentant avec une précision donnée, le signal r(t) ayant été reçu. La précision donnée est la valeur minimale du rapport signal sur bruit de quadrature, qui est considérée comme suffisante pour l'application envisagée. La valeur du bruit de quadrature est définie comme étant le carré de l'amplitude d'un vecteur d'erreur égal à la différence vectorielle entre l'échantillon complexe exact et l'échantillon complexe obtenu par les formules (3) pour les coefficients calculés par le dispositif 31. Avec cette définition, on peut, la plupart du temps, considérer le bruit de quadrature comme un bruit additif de moyenne nulle, dont le niveau est proportionnele à celui du signal à traiter.

Pour déterminer le nombre et la valeur des coefficients de pondération procurant un rapport signal sur bruit de quadrature supérieur à une limite fixée, il est nécessaire de vérifier que le rapport signal sur bruit de quadrature obtenu pour les coefficients calculés est supérieur ou égal à la limite fixée. Pour faire cette vérification, le dispositif 31 utilise une propriété, énoncée par le théorème de Weierstrass et le principe d'échantillonnage, qui est que toute fonction uniformément continue sur un intervalle peut être approximée, avec un écart maximum donné, par une somme finie de sinusoïdes de la bande physique. Ce théorème permet de conclure qu'il suffit d'optimiser les coefficients du numériseur analytique en ne considérant qu'un nombre fini de sinusoïdes appartenant à la bande du signal qui sera à traiter. Comme ce numériseur ne fait que calculer des combinaisons linéaires de valeurs d'échantillons, il est possible de considérer successivement chacune de ces sinusoïdes pour estimer le rapport signal sur bruit de quadrature apporté par des coefficients de pondération déterminés.

Considérons préalablement l'allure prise par les formules (3) lorsqu'on fait l'hypothèse que le signal appliqué à la borne d'entrée 10 est une simple sinusoïde $r(t)=\cos(\overline{\omega}t+\varphi)$ :

$$
(4) \quad
\begin{cases}
x(t) = a_0 \cdot \left[ \cos\left( \varpi t + \varpi \dfrac{\Delta t}{2} + \varphi \right) + \cos\left( \varpi - \dfrac{\varpi . \Delta t}{2} + \varphi \right) \right] + \\[2mm]
\quad a_1 \cdot \left[ \cos\left( \varpi t + \varpi . \dfrac{3\Delta t}{2} \right) + \varphi \right] + \cos\left[ \left( \varpi t - \quad \varpi . \dfrac{3\Delta t}{1} + \varphi \right) \right] + \ldots \\[2mm]
\quad + a_h \cdot \left[ \cos\left( \varpi t + \dfrac{\varpi(2h+1)\Delta t}{2} + \varphi \right) + \cos\left( \varpi t - \dfrac{\omega(2h+1)\Delta t}{2} + \varphi \right) \right] \\[4mm]
y(t) = b_0 \cdot \left[ \cos\left( \varpi t - \varpi \dfrac{\Delta t}{2} + \varphi \right) - \cos\left( \varpi t + \varpi \dfrac{\Delta t}{2} + \varphi \right) \right] \\[2mm]
\quad + b_1 \cdot \left[ \cos\left( \varpi t - \varpi \dfrac{3\Delta t}{2} + \varphi \right) - \cos\left( \varpi t + \dfrac{\varpi 3\Delta t}{2} + \varphi \right) \right] + \ldots \\[2mm]
\quad + b_h \cdot \left[ \cos\left( \varpi t - \dfrac{\varpi(2h+1)\Delta t}{2} + \varphi \right) - \cos\left( \varpi t + \dfrac{\varpi(2h+1)\Delta t}{2} + \varphi \right) \right]
\end{cases}
$$

Ces formules peuvent être simplifiées en posant :

$$
(5) \qquad \theta = \omega . \frac{\Delta t}{2} = \pi . \frac{Fc}{Fe},
$$

où Fc est la fréquence centrale du signal, et $F_e$ le rythme de calcul des valeurs x(t), y(t).

Les formules (4) deviennent alors :

$$(6) \begin{cases} x(t) = 2\left[a_0 \cos\theta + a_1 \cos 3\theta + \ldots + a_i \cos(2i+1)\theta\right] \cos(\varpi t + \varphi) \\ y(t) = 2\left[b_0 \sin\theta + b_1 \sin 3\theta + \ldots + b_i \sin(2i+1)\theta\right] \sin(\varpi t + \varphi) \end{cases}$$

Il apparaît que les deux voies de traitement qui calculent les valeurs x(t), y(t) ont respectivement un gain relatif $G_x$, $G_y$ qui est fonction des coefficients de pondération à déterminer :

$$(7) \begin{cases} G_x = a_0 \cos\theta + a_1 \cos 3\theta + \ldots + a_i \cos(2i+1)\theta \\ G_y = b_0 \sin\theta + b_1 \sin 3\theta + \ldots + b_i \sin(2i+1)\theta \end{cases}$$

où $Q_i$ est un polynôme classique, de degré i.

Une façon simple de déterminer ces coefficients consiste à exprimer que les gains $G_x$ et $G_y$ doivent rester au voisinage d'une valeur commune constante lorsque la variable θ varie. Les formules (7), donnant les valeurs de gain $G_x$, $G_y$ en fonction des coefficients de pondération, peuvent être mise sous une forme faisant apparaître un polynôme en cosθ pour $G_x$, et un polynôme en sinθ pour $G_y$. En effet, il est connu que pour toute valeur i entière, cos(2i+1)θ et sin(2i+1)θ peuvent être mis sous la forme :

$$(8) \begin{cases} \cos(2i+1)\theta = (-1)^i (\cos\theta).Q_i\left[(\cos\theta)^2\right] \\ \sin(2i+1)\theta = (\sin\theta).Q_i\left[(\sin\theta)^2\right] \end{cases}$$

où $Q_i$ est un polynome classique, de degré i.

Les gains Gx et Gy peuvent donc être mis sous la forme suivante :

$$(9) \begin{cases} Gx = (\cos\theta). \sum_{i=0}^{h} (-1)^i a_i.Q_i\left[(\cos\theta)^2\right] \\ Gy = (\sin\theta) \sum_{i=0}^{h} b_i.Q_i\left[(\sin\theta)^2\right] \end{cases}$$

La détermination des coefficients de pondération $a_i$ pour i=0, ..,h revient donc à déterminer les coefficients d'un polynôme, en cosθ, tels que ce polynôme pratiquement constant autour de la valeur cosθ. De même la détermination des coefficients $b_i$ pour i = 0 , ... , h revient à déterminer les coefficients d'un polynôme en sinθ, tels que ce polynôme pratiquement constant autour de la valeur sinθ. Si le nombre (2h+2) de coefficients de pondération est fixé à priori, les coefficients de pondération peuvent être déterminés en une seule itération. Sinon, plusieurs itérations sont éventuellement nécessaires pour déterminer des coefficients de pondération correspondant à des valeurs de h croissantes, jusqu'à obtenir une estimation du rapport signal sur bruit de quadrature qui soit supérieure à une limite donnée.

Pour déterminer le rapport signal sur bruit de quadrature, il est nécessaire de faire apparaître un gain G commun aux deux voies de traitement :

$$Gx = G + \varepsilon$$

$$G_y = G - \varepsilon$$

Le terme $\varepsilon$ traduit l'écart entre le gain relatif, respectivement Gx et Gy, de chacune des voies par rapport au gain commun G. Le rapport signal sur bruit de quadrature est alors estimé par la formule suivante:

$$(10) \qquad \frac{S}{N} = \frac{G^2}{\varepsilon^2} \cong 4 \left[ \frac{G_y^2 + G_x^2}{G_y^2 - G_x^2} \right]^2$$

où $G_x$ et $G_y$ sont respectivement les valeurs du gain relatif dans chacune des deux voies pour la valeur de $\theta$ correspondant à une fréquence située en fait à la limite de la bande où peut se situer le signal à traiter.

Une comparaison entre la valeur de cette estimation et une valeur limite permet de savoir si le nombre (2h+2) des échantillons, et des coefficients de pondération, qui vient d'être déterminé est suffisant pour obtenir un rapport signal sur bruit de quadrature suffisant pour l'application considérée. S'il n'est pas suffisant, le nombre h doit être incrémenté et de nouvelles valeurs de coefficients doivent donc être déterminées.

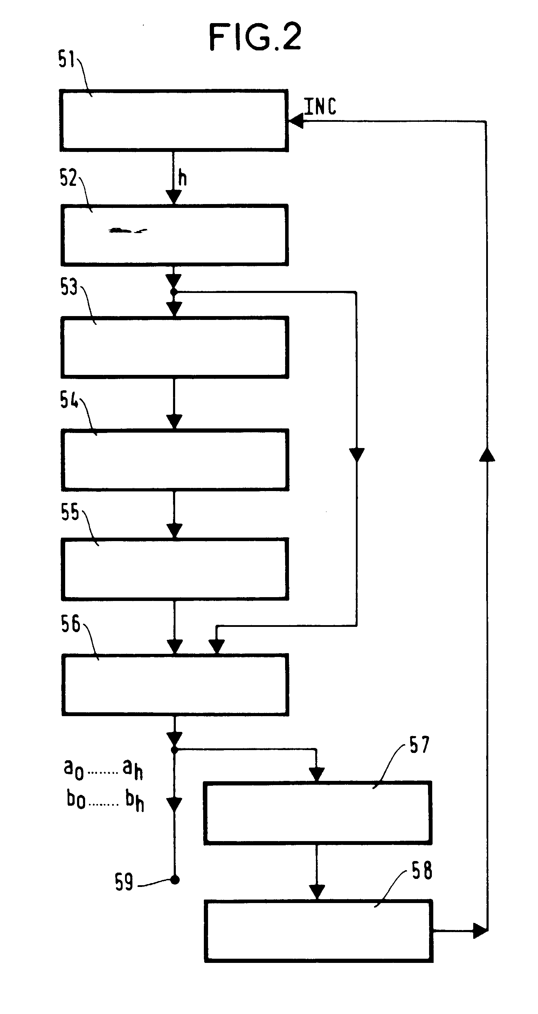

La figure 2 représente le schéma synoptique d'un exemple de réalisation du dispositif de calcul 31 déterminant le nombre (2h+2) de coefficients de pondération et leurs valeurs $a_o$, ...$a_h$, $b_o$, ..., $b_h$, pour prendre en compte 2h+2 valeurs d'échantillon. Cet exemple de réalisation est constitué de dispositifs de calcul discrets, mais il pourrait aussi bien être constitué d'un processeur convenablement programmé. Il comporte :

- un dispositif de calcul 51 pour incrémenter le nombre h, en prenant, pour valeur initiale h= 1; la valeur de h pouvant être incrémentée ultérieurement sous la commande d'un signal d'incrémentation INC, si l'estimation du rapport signal sur bruit de quadrature montre qu'il est inférieur à la limite donnée;
- un dispositif de calcul 52, recevant le nombre h fourni par le dispositif 51, pour remplacer les lignes trigométriques $\cos(2i+1)\theta$ et $\sin(2i+1)\theta$, pour i=0, ..., h, respectivement par leurs expressions polynomiales classiques de la forme (8), pour obtenir deux polynômes de la forme (9) donnant les gains relatifs $G_x$ et $G_y$;
- un dispositif de calcul 53, recevant les deux polynomes (9) déterminés par le dispositif 52, pour calculer les 2h premières dérivées des deux polynomes (9) et pour constituer un système de 2h équations linéaires à coefficients entiers, en écrivant que ces 2h premières dérivées s'annulent, autour respectivement de la valeur $\cos\theta$ pour $G_x$, autour de la valeur $\sin\theta$ pour $G_y$, pour $\theta = \frac{Fc}{Fe}$, en approximant la valeur de $\cos^2\theta$ par une fraction rationnelle;
- un dispositif de calcul 54, recevant ce système d'équations, pour le résoudre selon un algorithme classique ; la résolution de ce système fournissant une valeur pour chacun des coefficients $a_1$, ..., $a_h$, respectivement $b_1$, ..., $b_h$ en fonction de $a_0$, respectivement $b_0$, sous forme rationnelle;
- un dispositif de calcul 55, recevant les valeurs de coefficient calculées par le dispositif 54, pour les multiplier par un même facteur afin qu'ils aient une forme entière fonction de $a_0$, respectivement $b_0$; ce facteur commun pouvant être le plus petit commun multiple des valeurs obtenues pour les coefficients $a_1$, ..., $a_h$, respectivement les coefficients $b_1$, ..., $b_h$;
- un dispositif de calcul 56, recevant les valeurs de coefficient calculées par le dispositif 55, et recevant les formules (9) déterminées par le dispositif 52 pour calculer une valeur de $a_0$, respectivement $b_0$, tels que les gains relatifs:

$$(9) \quad \begin{cases} G_x = (\cos\theta) . \sum_{i=0}^{h} (-1)^i a_i . Q_i \left[ (\cos\theta)^2 \right] \\ G_y = (\sin\theta) \sum_{i=0}^{h} b_i . Q_i \left[ (\sin\theta)^2 \right] \end{cases}$$

soient approximativement égaux pour $\theta = \pi \dfrac{F_c}{F_e}$; et en déduire une valeur pour chacun des coefficients $a_0$, ..., $a_h$, $b_0$, ..., $b_h$;

- un dispositif de calcul 57, recevant ces valeurs de coefficients, pour calculer le rapport sur bruit de quadrature conformément à la formule (10) :

$$(10) \quad \frac{S}{N} = 4 \left[ \frac{G_y^2 + G_x^2}{G_y^2 - G_x^2} \right]^2$$

- un comparateur 58 recevant la valeur de ce rapport pour comparer ce rapport à une valeur limite prédéterminée définissant le rapport signal sur bruit de quadrature minimal tolérable; et fournir au dispositif 51 un signal INC pour incrémenter la valeur de h, si le rapport est inférieur à la valeur limite, ou bien valider la valeur courante de h et les valeurs de coefficient qui viennent d'être déterminées, si la valeur du rapport est supérieure ou égale à la valeur limite.

On montre que les polynômes $Q_i(x)$ mentionnés précédemment ont les propriétés suivantes :

$$(11) \quad Q_0(x) = 1$$

$$(12) \quad Q_1(x) = 3-4x$$

$$(13) \quad Q_2(x) = 5-20x + 16x^2$$

$$(14) \quad Q_3(x) = 7-56x + 112x^2 - 64x^3$$

$$(15) \quad Q_i(x) = (1-2x).Q_{i-1}(x) + 2(-1)^{i-1}.(1-x).Q_{i-1}(1-x)$$

En outre ces polynômes ont les propriétés suivantes :

$$(16) \quad Q_i(O) = Q_{i-1}(0) + 2$$

$$(17) \quad Q_i\left(\frac{1}{2}\right) = (-1)^{i-1} . Q_{i-1}\left(\frac{1}{2}\right)$$

$$(18) \quad Q_i(1) = (-1)^i$$

A titre d'exemple considérons la mise en oeuvre de ce dispositif de calcul 31 quand le nombre h courant est égal à 2. Pour déterminer les coefficients de pondération $a_0$, $a_1$, $a_2$, $b_2$, $b_0$, $b_1$, $b_2$, le dispositif 52, remplace dans les équations (2) l'expression générale des valeurs des échantillons :

$$r\left(t - \frac{\Delta t}{2}\right), \qquad r\left(t + \frac{\Delta t}{2}\right), \qquad r\left(t - \frac{3\Delta t}{2}\right),$$

$$r\left(t + \frac{3\Delta t}{2}\right), r\left(t - \frac{5\Delta t}{2}\right), r\left(t + \frac{5\Delta t}{2}\right)$$

par les valeurs des échantillons d'une sinusoïde hypothétique $r(t)=\cos(\overline{\omega}t+\varphi)$, puis en posant $\theta=\frac{\overline{\omega}\Delta t}{2}$. Les formules (9), des gains $G_x$ et $G_y$, prennent alors la forme suivante, dans cet exemple :

$$(19)\begin{cases} G_x = \cos\theta\left[a_0 - a_1\left(3 - 4\cos^2\theta\right) + a_2\left(5 - 20\cos^2\theta + 16\cos^4\theta\right)\right] \\ G_Y = \sin\theta\left[b_0 + b_1\left(3 - 4\sin^2\theta\right) + b_2\left(5 - 20\sin^2\theta + 16\sin^4\theta\right)\right] \end{cases}$$

Pour trouver les valeurs des coefficients $a_0$, $a_1$, $a_2$, $b_0$, $b_1$, $b_2$ qui procurent aux gains $G_x$ et $G_y$ des valeurs approximativement égales, le dispositif 53 annule les deux premières dérivées de chacun des polynômes (19). Les $3x_i$ sont solutions d'un système homogène à 2 équations. Les $3b_i$ sont solution d'un système du même type en remplaçant $b_i$ par $(-1)i.b_i$, et $\cos\theta$ par $\sin\theta$.

$$(20)\begin{cases} a_0 - 3a_1 + 5a_2 + \left(12.a_1 - 60.a_2\right)\cos^2\theta + 80.a_2\cos^4\theta = 0 \\ 3a_1 - 15a_2 + 40.a_2.\cos^2\theta = 0 \\ b_0 + 3b_1 + 5b_2 - \left(12b_1 + 60.b_2\right)\sin^2\theta + 80.b_2.\sin^4\theta = 0 \\ 2b_1 + 15b_2 - 40.b_2 - 40.b_2.\sin^2\theta = 0 \end{cases}$$

Le dispositif 54 détermine, à une constante multiplicative près pour $a_0$, $a_1$, $a_2$, et à une constante multiplicative près pour $b_0$, $b_1$, $b_2$, la solution de ce système d'équation. Cette solution est la suivante :

$$(21)\begin{cases} a_0 = 10 - 40\cos^2\theta + 80\cos^4\theta \\ a_1 = 5 - \dfrac{40\cos^2\theta}{3} \\ a_2 = 1 \end{cases}$$

$$(22) \quad \begin{cases} b_0 = 10 - 40\sin^2\theta + 80\sin^4\theta \\[2mm] b_1 = -5 + \dfrac{40}{3}\sin^2\theta \\[2mm] b_2 = 1 \end{cases}$$

Pour déterminer les deux constantes multiplicatives, le dispositif 55 reporte cette solution dans les formules (19), qui deviennent alors :

$$(23) \quad \begin{cases} G_x = \left(96 - \dfrac{160}{3}\right)\cos^5\theta \\[3mm] G_y = \left(96 - \dfrac{160}{3}\right)\sin^5\theta \end{cases}$$

Le dispositif 55 détermine un facteur pour multiplier $a_0$, $a_1$, $a_2$ et un facteur pour multiplier $b_0$, $b_1$, $b_2$;

Pour qu'il y ait égalité de ces deux gains, pour la valeur centrale $\theta$, il faut que les coefficients $a_0$, $a_1$, $a_2$, donnés par les formules (21) soient multipliés par $\sin^5\theta$ et que les coefficients $b_0$, $b_1$, $b_2$ donnés par les formules (22) soient multipliés $\cos^5\theta$.

Compte tenu de ces constantes multiplicatives, les valeurs des coefficients sont donc :

$$(24) \quad \begin{cases} a_0 = \left(10 - 40\cos^2\theta + 80\cos^4\theta\right)\sin^5\theta \\[3mm] a_1 = \left(5 - \dfrac{40}{3}\cos^2\theta\right)\sin^5\theta \\[3mm] a_2 = \sin^5\theta \\[3mm] b_0 = \left(10 - 40\sin^2\theta + 80\sin^4\theta\right)\cos^5\theta \\[3mm] b_1 = \left(-5 + \dfrac{40}{3}\sin^2\theta\right)\cos^5\theta \\[3mm] b_2 = \cos^5\theta \end{cases}$$

Le dispositif 56 remplace alors $\theta$ par sa valeur :

$$\theta = \omega.\frac{\Delta t}{2} = \pi.\frac{F_c}{F_e},$$

et arrondit $\cos\theta$ et $\sin\theta$ à des valeurs rationnelles pour obtenir une valeur rationnelle pour chaque coefficient. Cette valeur rationnelle est fournie sur une borne de sortie 59.

Il est bon de noter que l'on peut modifier légèrement $F_c$ de façon à simplifier les valeurs des coefficients de la tête analytique.

Par exemple, si la tête analytique est destinée à numériser un signal centré sur la fréquence $F_c = 1{,}6$ kHz et si le rythme de calcul des couples de valeurs x(t), y(t) est $F_e = 8$ kHz, alors $\theta$ est approximativement égal à 0,628 rd et $\cos\theta$ est approximativement égal à 0,809. Pour simplifier la réalisation, la valeur de $\cos\theta$ est prise égale à une valeur rationnelle proche de 0,809 par exemple $\frac{4}{5}$. De même la valeur de $\sin\theta$ est prise égale à une valeur rationnelle $\frac{3}{5}$.

En reportant ces valeurs dans les formules (24), et en multipliant par des facteurs multiplicatifs convenables, les valeurs des coefficients sont ramenées aux valeurs entières suivantes :

$a_0 = 4172$      $a_1 = -859$      $a_2 = 243$
$b_0 = 6111$      $b_1 = -205$      $b_2 = 1024$

Dans le cas particulier où $F_c = \frac{F_e}{4}$ alors $\theta = \frac{\pi}{4}$ les formules (24) donnent : $a_0 = b_0 = 30$, $a_1 = -b_1 = -5$, $a_2 = b_2 = 3$

Ces valeurs sont très simples, il est donc intéressant de translater la fréquence d'un signal reçu, de telle sorte que cette condition soit réalisée, pour simplifier la réalisation des moyens de calcul réalisant les multiplications par ces coefficients. C'est une propriété générale qui est vraie quelle que soit le nombre des coefficients utilisés.

A titre d'exemple, considérons le calcul du rapport signal sur bruit pour le cas où le numériseur selon l'invention utilise quatre échantillons. Le procédé de calcul exposé ci-dessus fournit :

$a_0 = 3$      $a_1 = -1$
$b_0 = 3$      $b_1 = 1$

$$Gx = 3\cos\theta - 2\cos^3\theta$$

$$Gy = 3\sin\theta - 2\sin^3\theta$$

Le rapport signal sur bruit $\frac{S}{N}$ est alors donné par les formules (10) en remplaçant $\theta$ par $\frac{\pi}{2}.\frac{\Delta F}{Fc}$ où $\Delta F$ est la demi-bande occupée par le signal à traiter, et Fc la fréquence centrale de ce signal :

$$\frac{S}{N} = 4\left[\frac{G_x^2 + G_y^2}{G_y^2 - G_x^2}\right] = 4\left[\frac{1 + 3\cos 2\frac{\pi}{2}.\frac{\Delta F}{Fc}}{\sin 3\frac{\pi}{2}.\frac{\Delta F}{Fc}}\right]^2$$

Par exemple, pour $\frac{\Delta F}{Fc} = 0{,}55$ $\frac{S}{N} = 20$dB

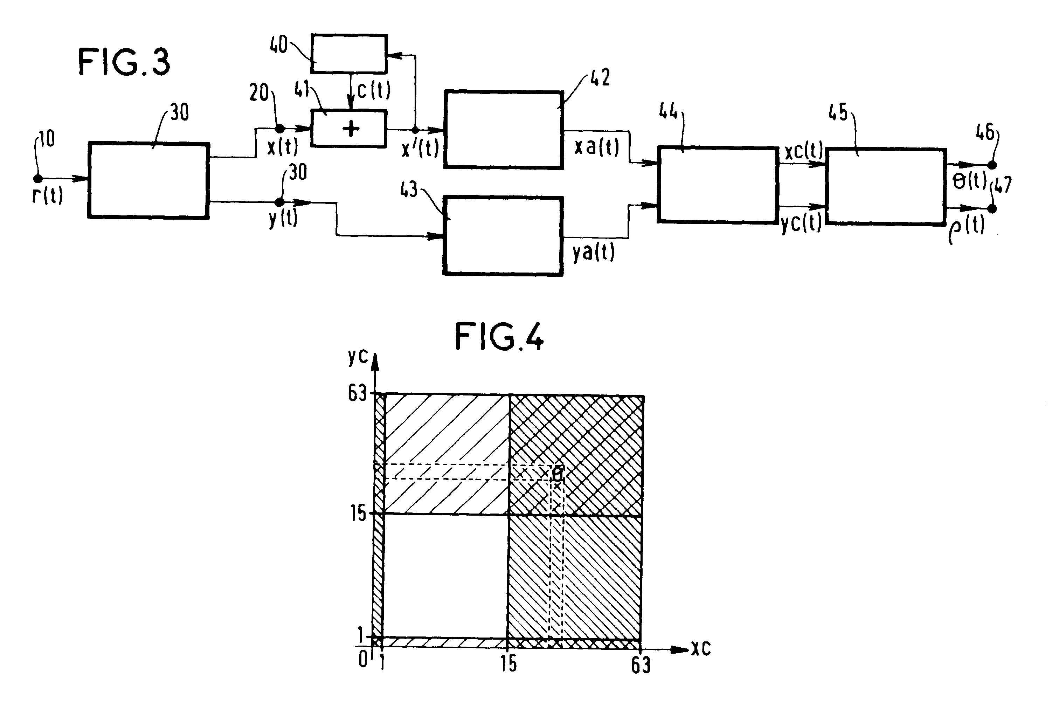

La figure 3 représente le schéma synoptique complet de l'ensemble de cet exemple de réalisation du numériseur analytique, selon l'invention. Il comporte :

- une première partie 39 qui est celle dont le schéma synoptique est représenté sur la figure 1, et qui fournit les valeurs cartésiennes x(t), y(t) de la première et la seconde composantes du signal reçu;
- un dispositif de calcul 40 réalisant un traitement statistique pour fournir un signal c(t) de correction de zéro;
- un additionneur 41 ayant une entrée reliée à une sortie du dispositif 40 et une entrée reliée à la borne de sortie 20 de la partie 39, pour additionner algébriquement la valeur c(t) du signal de correction, à la valeur x(t); une sortie de l'additionneur 41 fournissant une valeur corrigée x'(t) notamment à une entrée du dispositif 40;
- un dispositif de calcul 42 ayant une entrée reliée à la sortie de l'additionneur 41, et ayant une sortie fournissant une valeur arrondie xa(t) déduite de la valeur x'(t);
- un dispositif de calcul 43 ayant une entrée reliée à la borne de sortie 30 de la partie 39, et ayant une sortie fournissant une valeur arrondie ya(t) déduite de la valeur y(t);
- un dispositif de calcul 44 permettant d'augmenter la dynamique de ce numériseur analytique; comportant deux entrées reliées respectivement aux sorties des dispositifs de calcul 42 et 43, et ayant deux sorties fournissant respectivement deux valeurs xc(t) et yc(t);
- un dispositif de calcul 45 pour convertir les valeurs cartésiennes des composantes, xc(t) et yc(t), en deux valeurs polaires $\theta(t)$ et $\rho(t)$ qui sont fournies respectivement à deux bornes de sortie 46 et 47 du numériseur analytique.

Les dispositifs de calcul 40 à 45 peuvent être réalisés sous la forme d'un seul processeur convenablement programmé.

La composante y(t) ne comporte pas de composante continue car les valeurs des coefficients de pondération utilisées pour cette composante sont antisymétriques. Par contre, la composante x(t) peut comporter une composante continue dûe à une erreur de zéro. Dans le numériseur analytique, selon l'invention, la correction de cette erreur de zéro est facile à réaliser. Elle ne nécessite pas d'asservissement complexe. La valeur c(t) d'un signal de correction est additionnée à chaque valeur x(t) par l'additionneur 41. La valeur c(t) du signal de correction est évaluée par le dispositif de calcul 40 en calculant la valeur moyenne de x'(t) pour 1000 échantillons par exemple. L'erreur de zéro dérive lentement, par conséquent le calcul de la valeur du signal de correction peut être fait cycliquement et non pas de manière continue.

Les dispositifs de calcul 42 et 43 permettent de réduire le nombre de bits des deux mots binaires représentant respectivement les valeurs x'(t) et y(t). Par exemple, le nombre de bits de ces valeurs passe de 8 bits à 11 bits au moment des opérations de multiplication par les multiplieurs 14, 15, 16, ..., 24, 25, 26, représentés sur la figure 1. Il est souhaitable de ramener ce nombre de bits, inutilement grand, à un nombre égal à 8 bits qui est suffisant pour la dynamique du signal considéré et qui est facile à traiter par des dispositifs classiques de calcul numérique. Les dispositifs de calcul 42 et 43 permettent de supprimer 3 bits, mais en arrondissant à la valeur binaire, la plus proche, de façon à conserver le plus possible de précision.

Pour réduire de 11 à 8 le nombre de bits d'un premier mot binaire représentant la valeur x'(t), par exemple, le dispositif 42 forme un deuxième mot binaire en tronquant les trois bits de plus faible poids dans le premier mot binaire. Il forme un troisième mot binaire en tronquant les 3 bits de plus faible poids dans le premier mot binaire, puis incrémente la valeur de ce troisième mot binaire d'une unité. Il compare la valeur x'(t) avec celle du deuxième et celle du troisième mot binaire, puis choisit le deuxième ou le troisième mot binaire, en retenant celui dont la valeur est la plus proche de la valeur x'(t) du premier mot binaire.

Le dispositif de calcul 44 permet d'étendre la dynamique du numériseur analytique, en la doublant approximativement, sans qu'il soit nécessaire d'augmenter le nombre de coefficients de pondération. On démontre en effet, que pour un signal occupant une bande étroite centrée sur une fréquence $F_1$, le numériseur crée un signal parasite occupant une bande étroite centrée sur la fréquence $-F_1$. Dans le cas usuel où le rythme de calcul $F_e$ est égal à quatre fois la fréquence centrale $F_c$ du signal reçu, le signal parasite apparaît à une fréquence symétrique de la fréquence $F_1$ par rapport à la fréquence centrale $F_c$ du signal reçu. Il est donc possible de déterminer la fréquence centrale de ce signal parasite et de l'éliminer par un filtrage numérique classique.

Le dispositif de calcul 45 détermine le spectre du signal représenté par les valeurs xc(t), yc(t). Il détermine la raie ayant l'amplitude la plus élevée dans ce spectre. Il élimine la raie symétrique de ladite raie, par rapport à la fréquence centrale Fc du signal reçu, en réalisant un filtrage numérique éliminateur de bande, centré sur la fréquence de la raie symétrique. Il détermine une nouvelle raie ayant l'amplitude la plus élevée, non déjà traitée, puis il élimine la raie symétrique de cette nouvelle raie, par rapport à la fréquence centrale Fc du signal reçu. Puis il réitère ce processus, jusqu'à ce que toutes les raies d'amplitude supérieure à une valeur fixée ait été traitées.

Le dispositif de calcul 45 convertit les coordonnées cartésiennes $x_c(t)$, $y_c(t)$ en coordonnées polaires $\theta(t)$, $\rho(t)$ par des moyens particulièrement rapides et simples. La valeur $\theta(t)$ est théoriquement égale à $\text{arctg} \frac{y_c(t)}{x_c(t)}$.

Classiquement $\theta(t)$ est calculée en faisant la division de y(t) par x(t), au moyen de portes logiques ou d'un processeur, puis une table des valeurs de $\theta$ est adressée par le résultat de cette division. Le dispositif 45 détermine la valeur de $\theta$ par un autre procédé, plus rapide et plus simple à mettre en oeuvre, car il évite de faire la division de $Y_c(t)$ par $x_c(t)$.

Ce procédé consiste à ne conserver que s bits significatifs de la valeur absolue et un bit de signe pour la valeur $x_c(t)$, respectivement pour la valeur $y_c(t)$; s étant un nombre fixé et les s bits conservés ayant le même rang dans les mots binaires représentant ces deux valeurs; et les bits significatifs éliminés étant toujours des bits de plus faible poids.

Il consiste ensuite à concaténer ces deux 2s bits significatifs, afin de constituer une adresse; puis à adresser une mémoire morte comportant $2^{2s}$ valeurs approchées de $\theta$, pour y lire une valeur de $\theta$. Cette mémoire morte, non représentée, est intégrée au dispositif 45.

Par exemple, si s est pris égal à 4, et si :

$$xc(t) = 0\ \underline{0100}\ 0$$

$$yc(t) = O\ \underline{11O1}\ 1$$

le dispositif 45 retient les 4 bits soulignés. Le bit à gauche est éliminé car il n'est significatif pour aucune des deux valeurs. Le bit à droite est éliminé, car le nombre s de bits à conserver a été fixé à priori à 4.

La concaténation des 2s bits retenus fournit une adresse de 8 bits seulement :

01001101

qui est utilisée pour lire une valeur approchée de : $\theta = \text{arctg} \frac{y_c(t)}{x_c(t)}$ dans une mémoire morte. Etant adressée par 8 bits seulement, cette mémoire a une capacité beaucoup plus réduite que si elle était adressée par les valeurs $x_c(t)$ et $y_c(t)$ qui sont représentées par 16 bits au total.

La figure 4 illustre ce procédé de détermination de θ. Elle représente le champ de toutes les valeurs $x_c(t)$ possibles et de toutes les valeurs $y_c(t)$ possibles. Elle représente en blanc le champ des adresses effectivement utilisées, et représente par des hachures le champ des adresses qui ne seront jamais utilisées. Dans cet exemple, la capacité de mémoire effectivement utilisée est inférieure à un quart de la capacité qui serait nécessaire si tous les bits de xc(t) et de yc(t) étaient utilisés. La suppression du dernier bit à droite rend inaccessible les valeurs de θ correspondant à $x_c=$ 0 ou 1, et les valeurs yc=0 ou 1. La suppression du dernier bit à gauche rend inaccessible les valeurs de θ correspondant à $x_c$=16 à 63 et à $y_c$ = 16 à 63.

En pratique, on peut se limiter aux fréquences d'échantillonnage $F_e$ telles qu $\frac{F_c}{F_e} =\pm \frac{1}{4}$ +k avec k entier positif ou nul. La théorie du bruit de quadrature montre alors que le rapport signal sur bruit de quadrature ne dépend que du rapport de la bande utile divisée par la fréquence d'échantillonnage.

Ainsi, on peut démoduler un signal 4 phases à 300 Mb/s soit 150 Méga-symboles par seconde occupant une bande de 150 MHz par un échantillonnage réel à 450 MHz (soit une paire analytique en dehors des transitions) à condition de prendre une fréquence centrale (intermédiaire) voisine de

$$\left(5+\frac{1}{4}\right)150 \ \mathtt{MHz}$$

c'est-à-dire 788 MHz.

Les gains de quadrature sont :

$$\begin{cases} G_x & = a_0 \cos\theta + a_1 \cos3\theta +...+ a_h \cos(2h+1)\theta \\ G_y & = b_0 \sin\theta + b_1 \sin3\theta +... +b_h \sin(2h+1)\theta \end{cases}$$

Les conditions de symétrie du problème par rapport à $\theta = \pm\frac{\pi}{4}$ montrent que l'on a $a_i =(-1)^i b_i$.

$$\begin{cases} \cos(2h+1)\theta & = (\cos \theta)(-1)^h Q_h \left(\cos^2\theta\right) = \frac{1}{\sqrt{2}} (-1)^h Q_h \\ \sin(2h+1)\theta & = (\sin \theta) Q_h \left(\cos^2 \theta\right) = \frac{1}{\sqrt{2}} Q_h \end{cases}$$

avec

$$Q_h = Q_h\left(\frac{1}{2}\right) = (-1)^{h-1} Q_{h-1}$$

et $\left|Q_h\right| = 1$

| i= | 0 | 1 | 2 | 3 | 4 | 5 | 6 | 7 |
|----|---|---|----|----|---|---|----|----|
| $Q_i$= | 1 | 1 | -1 | -1 | 1 | 1 | -1 | -1 |

A une constante multiplicative près, on détermine les valeurs de $b_i$ en annulant les h premières dérivées de $G_y$ par rapport à θ.

Pour $G'_y$ :

$$b_0 \cos\theta + 3b_1 \cos3\theta + 5 b_2 \cos5\theta = 0$$

$$b_0 - 3b_1Q_1 + 5b_2Q_2 = 0$$

$$b_0 - 3b_1 - 5\,b_2 = 0$$

Pour $G''_y$ :

$$b_0 \sin\theta + 9b_1 \sin3\theta + 25b_2\sin 5\theta = 0$$

$$b_0\,Q_0 + 9b_1Q_1 + 25\,b_2\,Q_2 = 0$$

$$b_0 + 9b_1 - 25\,b_2 = 0$$

La solution entière minimale est la suivante :

$$b_0 = 30,\ b_1 = 5,\ b_2 = 3$$

$$a_0 = 30,\ a_1 = -5,\ a_2 = 3$$

Il est donc aisé de précalculer les listes de coefficients $b_i$ et de les stocker dans une table qui peut être consultée au cours du processus d'adaptation de la tête analytique. Bien entendu, on pourrait compléter cette table par une évaluation du bruit de quadrature en fonction de la bande pour chaque liste de coefficients.

**Revendications**

1.  Procédé de calcul de coefficients de pondération pour un numériseur analytique pour traitement de signal, ce numériseur comportant :

    -   des moyens (1 à 3) pour échantillonner un signal analogique à traiter, et pour convertir la valeur analogique de chaque échantillon en une valeur numérique;
    -   des premiers moyens de calcul (4 à 8, 11 à 19) fournissant une suite de valeurs numériques x(t), chaque valeur étant calculée en additionnant 2h+2 valeurs fournies par les moyens pour numériser, après les avoir pondérées respectivement par des coefficients $a_0$, ..., $a_h$, $a_h$, .... $a_0$, entiers, non nuls;
    -   des seconds moyens de calcul (4 à 8, 21 à 29) fournissant une suite de valeurs numériques y(t), chaque valeur étant calculée en additionnant 2h+2 valeurs fournies par les moyens pour numériser, après les avoir pondérées respectivement par des coefficients $b_0$, ..., $b_h$, $-b_h$, .... $-b_0$, entiers, non nuls;
    -   des moyens (31) pour fournir aux premiers et aux seconds moyens de calcul les valeurs des coefficient $a_0$, ..., $a_h$, $b_0$, ..., $b_h$;

    caractérisé en ce que, pour un numériseur calculant des couples de valeurs x(t), y(t) à un rythme fixé Fe, pour un signal ayant une fréquence centrale Fc et une largeur de bande B prédéterminées, et pour un nombre h prédéterminé, le calcul des coefficients $a_0$,...,$a_h$ et $b_0$,...,$b_h$ consiste à :

    -   remplacer les lignes trigométriques cos $(2i + 1)\theta$ et sin $(2i+1)\theta$ pour i = 0, ..., h, respectivement par des expressions polynomiales classiques, respectivement de la forme :

$$\begin{cases} \text{Cos}(2i+1)\theta = (-)^i (\text{Cos}\theta).Q_i\left[(\text{Cos}\theta)^2\right] \\ \text{Sin}(2i+1)\theta = (\text{Sin}\theta).Q_i\left[(\text{Sin}\theta)^2\right] \end{cases}$$

où $Q_i$ est un polynôme classique de degré i, dans les polynômes suivants :

$$\begin{cases} \text{Gx} = a_0\cos\theta + a_1\cos 3\theta + ... + a_i\cos(2i+1)\theta + ... + a_h\cos(2h+1)\theta \\ \text{Gy} = b_0\sin\theta + b_1\sin 3\theta + ... + b_i\sin(2i+1)\theta + ... + b_h\sin(2h+1)\theta \end{cases}$$

pour obtenir deux polynômes appelés gains relatifs des premiers et seconds moyens de calcul, et qui sont de la forme :

$$\text{Gx} = (\text{Cos}\theta).\sum_{i=0}^{h}(-1)^i a_i.Q_i.\left[(\text{Cos}\theta)^2\right]$$

$$\text{Gy} = (\text{Sin}\theta).\sum_{i=0}^{h} b_i.Q_i.\left[(\text{Sin}\theta)^2\right]$$

- puis annuler les h premières dérivées des deux gains relatifs $G_x$, $G_y$, respectivement autour de la valeur centrale $\cos\theta$ et autour de la valeur centrale $\sin\theta$, pour $\theta = \pi\frac{F_c}{F_e}$, en approximant $\cos^2\theta$ par une fraction rationnelle;
- puis résoudre par un algorithme classique le système de 2h équations linéaires à coefficients entiers, ainsi obtenu; la résolution de ce système fournissant des valeurs des coefficients $a_0$, ..., $a_h$, respectivement $b_0$, ..., $b_h$ en fonction de $a_0$, respectivement b0, sous forme rationnelle;
- multiplier par un même facteur entier tous les coefficients $a_1$,..., $a_h$, respectivement $b_1$, ..., $b_h$, pour les mettre sous une forme entière fonction de $a_0$, respectivement $b_0$;
- calculer la valeur de $a_0$, respectivement $b_0$, telle que les gains relatifs $G_x$ et Gy soient approximativement égaux pour $\theta = \pi\frac{F_c}{F_e}$, avec une précision donnée fonction de l'application du numériseur.

2.  Numériseur analytique pour traitement de signal, comportant :

- des moyens (1 à 3) pour échantillonner un signal analogique à traiter, et pour convertir la valeur analogique de chaque échantillon en une valeur numérique;
- des premiers moyens de calcul (4 à 8, 11 à 19) fournissant une suite de valeurs numériques x(t), chaque valeur étant calculée en additionnant 2h+2 valeurs fournies par les moyens pour numériser, après les avoir pondérées respectivement par des coefficients $a_0$, ..., $a_h$, $a_h$, .... $a_0$, entiers, non nuls;
- des seconds moyens de calcul (4 à 8, 21 à 29) fournissant une suite de valeurs numériques y(t), chaque valeur étant calculée en additionnant h valeurs fournies par les moyens pour numériser, après les avoir pondérées respectivement par des coefficients $b_0$,...,$b_h$ ,..., $b_h$,...,-$b_0$ entiers, non nuls;
- des moyens (31) pour fournir aux premiers et aux seconds moyens de calcul les valeurs des coefficient $a_0$, ..., $a_h$, $b_0$, ..., $b_h$;

caractérisé en ce que le nombre h+1 des coefficients $a_0$,...,$a_h$, respectivement $b_0$,...,$b_h$, et leur valeur sont variables en fonction de la fréquence centrale $F_c$ du signal et de la largeur de bande B du spectre le signal à traiter;

et en ce que les moyens (31) pour fournir les valeurs des coefficients $a_0$, ..., $a_h$, $b_0$, ..., $b_h$, comportent :

- des moyens (51) pour incrémenter le nombre h, en prennant initialement h=1, le nombre h pouvant être incrémenté ultérieurement sous la commande d'un signal d'incrémentation;

- des moyens (52) pour remplacer les lignes trigonométriques cos(2i + 1)θ et sin(2i+1)θ pour i= 0,..., h, respectivement par leurs expressions polynomiales classiques de la forme :

$$\begin{cases} \cos(2i+1)\theta = (-1)^i(\cos\theta).Q_i\left[(\cos\theta)^2\right] \\ \sin(2i+1)\theta = (\sin\theta).Q_i\left[(\sin\theta)^2\right] \end{cases}$$

où $Q_i$ est un polynôme classique de degré i, dans les polynomes suivants :

$$\begin{cases} G_x = a_0\cos\theta + a_1\cos3\theta + ... + a_i\cos(2i+1)\theta + ... + a_h\cos(2+1)\theta \\ G_y = b_0\sin\theta + b_1\sin3\theta + ... + b_i\sin(2i+1)\theta + ... + b_h\sin(2h+1)\theta \end{cases}$$

pour obtenir deux polynômes appellés gains relatifs des premiers et seconds moyens de calcul, et qui sont de la forme :

$$Gx = (\cos\theta).\sum_{i=0}^{h}(-1)^i.a_i.Q_i\left[(\cos\theta)^2\right]$$

$$Gy = (\sin\theta)\sum_{i=0}^{h}b_i.Q_i\left[(\sin\theta)^2\right]$$

- des moyens (53) pour annuler les h premières dérivées des deux gains relatifs $G_x$, $G_y$ respectivement autour de la valeur cosθ et autour de la valeur sinθ, pour $\theta = \pi\frac{Fc}{Fe}$ , en approximant $\cos^2\theta$ par une fraction rationnelle;

- des moyens (54) pour résoudre, par un algorithme classique, le système de 2h équations linéaires à coefficients entiers, ainsi obtenu; la résolution de ce système fournissant des valeurs des coefficients $a_1,...,a_h$, respectivement $b_1,..., b_h$, en fonction de $a_0$, respectivement $b_0$, sous forme rationnelle;

- des moyens (55) pour multiplier par un même facteur entier les valeurs ainsi obtenues, pour tous les coefficients $a_1,...,a_h$, respectivement $b_1,...,b_h$, pour les mettre sous une forme entière fonction de $a_0$, respectivement $b_0$;

- des moyens (56) pour calculer une valeur de $a_0$, respectivement $b_0$, telles que les gains relatifs Gx, Gy respectifs des premiers (4 à 8, 11 à 19) et seconds moyens (4 à 8, 21 à 29) de calcul soient approximativement égaux pour $\theta = \pi\frac{Fc}{Fe}$;

- des moyens (57) pour calculer une estimation du rapport signal sur bruit de quadrature, égale à :

$$\frac{S}{N} = 4\left[\frac{G_y^2 + G_x^2}{G_y^2 - G_x^2}\right]^2$$

- des moyens (58) pour comparer ce rapport à une valeur limite prédéterminée définissant le rapport signal sur bruit de quadrature minimal tolérable; ces moyens fournissant un signal d'incrémentation aux moyens (51) pour incrémenter le nombre h, si la valeur du rapport est inférieure à la valeur limite, ou fournissant un signal de validation de la valeur courante de h et des valeurs de coefficient qui viennent d'être déterminées, si la valeur du rapport est supérieure ou égale à la valeur limite.

3. Numériseur selon la revendication 2, caractérisé en ce que les premiers moyens de calcul comportent en outre :

- des moyens (41) pour estimer l'erreur de zéro sur une suite de valeurs x(t) de la première composante, et fournir un signal de correction ayant une valeur c(t);
- des moyens pour additionner la valeur c(t) du signal de correction, à chaque valeur de x(t) calculée par les premiers moyens de calcul.

4. Numériseur selon la revendication 2, caractérisé en ce que les premiers et seconds moyens de calcul comportent en outre, chacun, des moyens (42, 43) pour réduire le nombre de bits d'un premier mot binaire représentant la valeur absolue de x(t), respectivement y(t), ces moyens (42, 43) comportant des moyens pour :

- former un deuxième mot binaire, en tronquant b bits de moindre poids, dans le premier mot binaire; b étant un nombre fixé;
- formant un troisième mot binaire en tronquant b bits, de moindre poids, dans le premier mot binaire, puis en incrémentant sa valeur d'une unité;
- comparer la valeur x(t), respectivement y(t), avec celle du deuxième et celle du troisième mot binaire;
- représenter la valeur de x(t), respectivement y(t), par celui dont la valeur est la plus proche de la valeur du premier mot binaire.

5. Numériseur selon la revendication 2, caractérisé en ce que pour augmenter la dynamique de ce numériseur, les premiers et seconds moyens de calcul comportent en outre des moyens (44) pour :

- calculer l'amplitude des raies spectrales du signal à traiter, à partir des valeurs x(t), y(t) déterminées par les premièrs et les deuxièmes moyens de calcul (39);
- déterminer la raie d'amplitude la plus élevée parmi ces raies;
- éliminer la raie symétrique de ladite raie, par rapport à la fréquence centrale $F_c$ du signal;
- déterminer une nouvelle raie d'amplitude la plus élevé, non déjà traitée;
- éliminer la raie symétrique de cette nouvelle raie, par rapport à la fréquence centrale $F_c$ du signal;
- réitérer ce processus jusqu'à ce que toutes les raies d'amplitude supérieure à une valeur fixée aient été traitées.

6. Numériseur selon la revendication 2, dans lequel les premiers et seconds moyens de calcul comportent en outre des moyens (45) pour convertir chaque couple de valeurs x(t), y(t) en deux coordonnées polaires $\rho$ et $\theta$; caractérisé en ce que, pour calculer $\theta$, ces moyens pour convertir comportent des moyens pour :

- ne conserver que s bits significatifs de valeur absolue et un bit de signe pour la valeur x(t), respectivement pour la valeur y(t); s étant un nombre fixé, les s bits conservés ayant le même rang dans la valeur de x(t) et dans la valeur de y(t); et les bits significatifs non conservés étant toujours des bits de plus faible poids;
- pour concaténer ces 2s bits significatifs afin de constituer une adresse;

et comportent une mémoire morte, contenant $2^{2s}$ valeurs approchées de $\theta$, adressée par ladite adresse pour y lire une valeur $\theta$ pour chaque couple de valeurs x(t), y(t).

7. Numériseur selon la revendication 2, caractérisé en ce que le rythme de calcul $F_e$ et la fréquence centrale $F_c$ du signal reçu sont liés par la relation $\frac{F_c}{F_e} \pm \frac{1}{4} + k$ où k est un nombre entier positif ou nul.

**Patentansprüche**

1. Verfahren zur Berechnung von Wichtungsfaktoren für ein analytisches Digitalisiergerät für die Signalverarbeitung, wobei dieses Digitalisiergerät aufweist:

- Mittel (1 bis 3) zum Abtasten eines zu verarbeitenden analogen Signals und zum Umwandlen des Analogwertes jeder Abtastprobe in einen Digitalwert;

- erste Berechnungsmittel (4 bis 8, 11 bis 19), die eine Folge von Digitalwerten x(t) liefern, wobei jeder Wert berechnet wird, indem 2h+2 von den Mitteln zum Digitalisieren gelieferte Werte addiert werden, nachdem sie jeweils mit ganzzahligen Faktoren $a_0$, ..., $a_h$, $a_h$, ..., $a_0$, ungleich Null gewichtet wurden;
- zweite Berechnungsmittel (4 bis 8, 21 bis 29), die eine Folge von Digitalwerten y(t) liefern, wobei jeder Wert berechnet wird, indem 2h+2 von den Mitteln zum Digitalisieren gelieferte Werte addiert werden, nachdem sie jeweils mit ganzzahligen Faktoren $b_0$, ... $b_h$, $-b_h$, ... $-b_0$ ungleich Null gewichtet wurden;
- Mittel (31) zum Liefern der Werte der Faktoren $a_0$, ..., $a_h$, $b_0$, ... $b_h$ an die ersten und zweiten Berechnungsmittel,

dadurch gekennzeichnet, daß bei einem Digitalisiergerät, das Paare von Werten x(t), y(t) mit einem festen Takt Fe berechnet, für ein Signal, das eine vorbestimmte Bandmittenfrequenz Fc und eine vorbestimmte Bandbreite B hat, und für eine vorbestimmte Anzahl h die Berechnung der Koeffizienten $a_0$, ..., $a_h$ und $b_0$, ... $b_h$ darin besteht:

- die trigonometrischen Reihen cos(2i+1)θ und sin(2i+1)θ für i = 0, ..., h in den folgenden Polynomen

$$\begin{cases} Gx = a_0\cos\theta + a_1\cos3\theta + ... + a_i\cos(2i+1)\theta + ... + a_h\cos(2h+1)\theta \\ Gy = b_0\sin\theta + b_1\sin3\theta + ... + b_i\sin(2i+1)\theta + ... + b_h\sin(2h+1)\theta \end{cases}$$

jeweils durch konventionelle Polynomausdrücke, jeweils in der Form

$$\begin{cases} \cos(2i+1)\theta = (-)^i(\cos\theta).Q_i\left[(\cos\theta)^2\right] \\ \sin(2i+1)\theta = (\sin\theta).Q_i\left[(\sin\theta)^2\right] \end{cases}$$

worin Qi ein konventionelles Polynom vom Grad i ist, zu ersetzen, um zwei Polynome zu erhalten, die relative Verstärkungen der ersten und zweiten Berechnungsmittel genannt werden und die die Form haben:

$$Gx = (\cos\theta).\sum_{i=0}^{h}(-1)^i a_i.Q_i.\left[(\cos\theta)^2\right]$$

$$Gy = (\sin\theta).\sum_{i=0}^{h}b_i.Q_i.\left[(\sin\theta)^2\right]$$

- dann die h ersten Ableitungen der beiden relativen Verstärkungen $G_x$, $G_y$ um den zentralen Wert cosθ bzw. um den zentralen Wert sinθ für $\theta = \pi\frac{F_c}{F_e}$ auf Null zu setzen, indem $\cos^2\theta$ durch einen rationalen Bruch angenähert wird;
- dann das so erhaltene System von 2h linearen Gleichungen mit ganzzahligen Koeffizienten durch einen konventionellen Algorithmus zu lösen; wobei die Lösung dieses Systems Werte der Faktoren $a_0$, ..., $a_h$, bzw. $b_0$, ..., $b_h$ in Abhängigkeit von $a_0$ bzw. $b_0$ in rationaler Form liefert;
- alle Faktoren $a_1$, ..., $a_h$ bzw. $b_1$ ..., $b_h$ mit demselben ganzzahligen Faktor zu multiplizieren, um sie in eine ganzzahlige Form in Abhängigkeit von $a_0$ bzw. $b_0$ zu bringen;
- den Wert von $a_0$ bzw. $b_0$ zu berechnen, so daß die relativen Verstärkungen Gx und Gy für $\theta = \pi\frac{F_c}{F_e}$ annähernd gleich sind, mit einer gegebenen Genauigkeit in Abhängigkeit von der Anwendungen des Digitalisiergeräts.

2. Analytisches Digitalisiergerät zur Signalverarbeitung, welches aufweist:

- Mittel (1 bis 3) zum Abtasten eines zu verarbeitenden analogen Signals und zum Umwandeln des Analogwertes jeder Abtastprobe in einen Digitalwert;
- erste Berechnungsmittel (4 bis 8, 11 bis 19), die eine Folge von Digitalwerten x(t) liefern, wobei jeder Wert berechnet wird, indem 2h+2 von den Mitteln zum Digitalisieren gelieferte Werte addiert werden, nachdem sie jeweils mit ganzzahligen Faktoren $a_0$, ..., ..., $a_h$, $a_h$, ..., $a_0$, ungleich Null gewichtet wurden;
- zweite Berechnungsmittel (4 bis 8, 21 bis 29), die eine Folge von Digitalwerten y(t) liefern, wobei jeder Wert berechnet wird, indem h von den Mitteln zum Digitalisieren gelieferte Werte addiert werden, nachdem sie jeweils mit ganzzahligen Faktoren $b_0$, ... $b_h$, ..., $-b_h$, ... $-b_0$ ungleich Null gewichtet wurden;
- Mittel (31) zum Liefern der Werte der Faktoren $a_0$, ..., $a_h$, $b_0$, ... $b_h$ an die ersten und zweiten Berechnungsmittel,

dadurch gekennzeichet, daß die Anzahl h+1 der Faktoren $a_0$, ..., $a_h$ bzw. $b_0$ ..., $b_h$ und ihr Wert in Abhängigkeit von der Bandmittenfrequenz $F_c$ des Signals und von der Bandbreite B des Spektrums des zu verarbeitenden Signals variabel sind;
und daß die Mittel (31) zum Liefern der Werte der Faktoren $a_0$, ..., $a_h$, $b_0$, ..., $b_h$ aufweisen:

- Mittel (51) zum Inkrementieren der Zahl h, indem anfangs h=1 angenommen wird, wobei die Zahl h später unter Anweisung eines Inkrementierungssignals inkrementiert wird;
- Mittel (52) zum Ersetzen der trigonometrischen Reihen $\cos(2i+1)\theta$ und $\sin(2i+1)\theta$ für $i = 0, ..., h$ in den folgenden Polynomen

$$\begin{cases} G_x = a_0\cos\theta + a_1\cos3\theta + ... + a_i\cos(2i+1)\theta + ... + a_h\cos(2+1)\theta \\ G_y = b_0\sin\theta + b_1\sin3\theta + ... + b_i\sin(2i+1)\theta + ... + b_h\sin(2h+1)\theta \end{cases}$$

jeweils durch konventionelle Polynomausdrücke der Form

$$\begin{cases} \cos(2i+1)\theta = (-1)^i(\cos\theta).Q_i\left[(\cos\theta)^2\right] \\ \sin(2i+1)\theta = (\sin\theta).Q_i\left[(\sin\theta)^2\right] \end{cases}$$

worin $Q_i$ ein konventionelles Polynom vom Grad i ist, um zwei Polynome zu erhalten, die relative Verstärkungen der ersten und zweiten Berechnungsmittel genannt werden und die die Form haben:

$$G_x = (\cos\theta).\sum_{i=0}^{h}(-1)^i.a_i.Q_i\left[(\cos\theta)^2\right]$$

$$G_y = (\sin\theta)\sum_{i=0}^{h}b_i.Q_i\left[(\sin\theta)^2\right]$$

- Mittel (53) zum Nullsetzen der h ersten Ableitungen der beiden relativen Verstärkungen $G_x$, $G_y$ um den zentralen Wert $\cos\theta$ bzw. um den zentralen Wert $\sin\theta$ für $\theta = \pi\frac{F_c}{F_e}$, indem $\cos^2\theta$ durch einen rationalen Bruch angenähert wird;
- Mittel (54) zum Lösen des so erhaltenen Systems von 2h linearen Gleichungen mit ganzzahligen Koeffizienten durch einen konventionellen Algorithmus; wobei die Lösung dieses Systems Werte der Faktoren $a_1$, ... $a_h$, bzw. $b_1$ ..., $b_h$ in Abhängigkeit von $a_0$ bzw. $b_0$ in rationaler Form liefert;
- Mittel (55) zum Multiplizieren der so erhaltenen Werte mit demselben ganzzahligen Faktor für alle Faktoren

$a_1$, ..., $a_h$ bzw. $b_1$, .... $b_h$, um sie in eine ganzzahlige Form in Abhängigkeit von $a_0$ bzw. $b_0$ zu bringen;
- Mittel (56) zur Berechnung eines Wertes von $a_0$ bzw. $b_0$, so daß die jeweiligen relativen Verstärkungen Gx, Gy der ersten (4 bis 8, 11 bis 19) und zweiten Berechnungsmittel (4 bis 8, 21 bis 29) für $\theta = \pi\frac{F_c}{F_e}$ annähernd gleich sind;
- Mittel (57) zur Berechnung einer Schätzung des Verhältnisses Signal zu Quadraturrauschen gleich:

$$\frac{S}{N} = 4\left[\frac{G_y^2 + G_x^2}{G_y^2 - G_x^2}\right]^2$$

- Mittel (58) zum Vergleichen dieses Verhältnisses mit einem vorbestimmten Grenzwert, der das minimale zulässige Verhältnis Signal zu Quadraturrauschen definiert; wobei diese Mittel ein Inkrementierungssignal an Mittel (51) zum Inkrementieren der Zahl h liefern, wenn der Wert des Verhältnisses kleiner als der Grenzwert ist, oder ein Signal zur Validierung des laufenden Wertes von h und der Faktorenwerte, die gerade bestimmt wurden, wenn der Wert des Verhältnisses größer oder gleich dem Grenzwert ist.

3. Digitalisiergerät nach Anspruch 2, dadurch gekennzeichnet, daß die ersten Berechnungsmittel außerdem aufweisen:

- Mittel (41) zum Schätzen des Nullpunktfehlers auf einer Reihe von Werten x(t) der ersten Komponente und Liefern eines Korrektursignals, das einen Wert c(t) hat;
- Mittel zum Addieren des Wertes c(t) des Korrektursignals zu jedem von den ersten Berechnungsmitteln berechnetem Wert von x(t).

4. Digitalisiergerät nach Anspruch 2, dadurch gekennzeichnet, daß die ersten und zweiten Berechnungsmittel außerdem jweils Mittel (42, 43) zum Verringern der Bitanzahl eines ersten Binärwortes aufweisen, das den Absolutwert von x(t) bzw. y(t) darstellt, wobei diese Mittel (42, 43) Mittel aufweisen, um:

- ein zweites Binärwort zu bilden, indem b Bits mit geringerem Gewicht im ersten Binärwort abgebrochen werden; wobei b eine feste Zahl ist;
- ein drittes Binärwort zu bilden, indem b Bits mit geringerem Gewicht im ersten Binärwort abgebrochen werden, dann sein Wert um Eins erhöht wird;
- den Wert x(t) bzw. y(t) mit dem des zweiten und dem des tritten Binärwortes zu vergleichen;
- den Wert von x(t) bzw. y(t) durch denjenigen darzustellen, dessen Wert am nächsten beim Wert des ersten Binärwortes liegt.

5. Digitalisiergerät nach Anspruch 2, dadurch gekennzeichnet, daß zum Erhöhen der Dynamik dieses Digitalisiergeräts die ersten und zweiten Berechungsmittel außerdem Mittel (44) aufweisen, um:

- die Amplitude der Spektrallinien des zu verarbeitenden Signals ausgehend von den Werten x(t), y(t) zu berechnen, die von den ersten und zweiten Berechnungsmitteln (39) bestimmt wurden;
- die Linie mit der höchsten Amplitude unter diesen Linien zu bestimmen;
- die in bezug auf die Bandmittenfrequenz $F_c$ des Signals zu dieser Linie symmetrische Linie zu eliminieren;
- eine noch nicht verarbeitete neue Linie mit der höchsten Amplitude zu bestimmen;
- die in bezug auf die Bandmittenfrequenz $F_c$ des Signals zu dieser neuen Linie symmetrische Linie zu eliminieren;
- diesen Vorgang zu wiederholen, bis alle Linien mit einer Amplitude, die größer als ein fester Wert ist, verarbeitet wurden.

6. Digitalisiergerät nach Anspruch 2, bei dem die ersten und zweiten Berechnungsmittel außerdem Mittel (45) zum Umwandeln jedes Paares von Werten x(t), y(t) in zwei Polarkoordinaten $\rho$ und $\theta$ aufweist; dadurch gekennzeichnet, daß zum Berechnen von $\theta$ diese Mittel zum Umwandeln Mittel aufweisen, um:

- nur s signifikante Bits des Absolutwerts und ein Vorzeichenbit für den Wert x(t) bzw. für den Wert y(t) zu behalten; wobei s eine feste Zahl ist, wobei die s behaltenen Bits im Wert von x(t) und im Wert von y(t) den gleichen Rang haben; und wobei die nicht behaltenen, signifikanten Bits immer Bits mit geringerem Gewicht sind;

- zum Verketten dieser 2s signifikanten Bits, um eine Adresse zu bilden;

und einen durch die Adresse adressierten Totspeicher aufweisen, der $2^{2s}$ angenäherte Werte von θ enthält; um dort einen Wert θ für jedes Paar von Werten x(t), y(t) zu lesen.

7. Digitalisiergerät nach Anspruch 2, dadurch gekennzeichnet, daß der Berechnungstakt $F_e$ und die Bandmittenfrequenz $F_c$ des empfangenen Signals durch die Relation $\frac{F_c}{F_e} = \pm\frac{1}{4}$ +k verbunden sind, worin k eine positive ganze Zahl oder Null ist.

## Claims

1. Method of calculating weighting coefficients for an analytical digitiser for signal processing, said digitiser comprising:

- means (1 to 3) for sampling an analogue signal to be processed and for converting the analogue value of each sample into a digital value;
- first calculating means (4 to 8, 11 to 19) supplying a sequence of digital values x(t) each calculated by adding 2h+2 values supplied by the digitising means weighted by respective non-null integer coefficients $a_0$, ..., $a_h$, $a_h$ ..., $a_0$;
- second calculating means (4 to 8, 21 to 29) supplying a sequence of digital values y(t) each calculated by adding 2h+2 values supplied by the digitising means weighted by respective non-null integer coefficients $b_0$ ..., $b_h$, $-b_h$, ..., $-b_0$;
- means (31) for supplying to said first and second calculating means the values of the coefficients $a_0$, ..., $a_h$, $b_0$, ..., $b_h$;

characterised in that, for a digitiser calculating pairs of values x(t), y(t) at a fixed rate Fe for a signal having a predetermined centre frequency Fc and bandwidth B and for a predetermined number h, the calculation of the coefficients $a_0$, ..., ..., $a_h$ and $b_0$, ..., $b_h$ consists in:

- replacing the trigonometrical lines cos (2i + 1)θ and sin (2i + 1)θ for i = 0 ..., h, respectively, by standard polynomial expressions of the respective form:

$$\begin{cases} \text{Cos}(2i+1)\theta = (-)^i (\text{Cos}\theta) . Q_i\left[(\text{Cos}\theta)^2\right] \\ \text{Sin}(2i+1)\theta = (\text{Sin}\theta) . Q_i\left[(\text{Sin}\theta)^2\right] \end{cases}$$

where $Q_i$ is a standard ith degree polynomial, in the following polynomials:

$$\begin{cases} \text{Gx} = a_0\cos\theta + a_1\cos3\theta +...+ a_i\cos(2i+1)\theta +...+ a_h\cos(2h+1)\theta \\ \text{Gy} = b_0\sin\theta + b_1\sin3\theta +...+ b_i\sin(2i+1)\theta +...+ b_h\sin(2h+1)\theta \end{cases}$$

to obtain two polynomials called the relative gains of the first and second calculating means, in the form:

$$Gx = (\cos\theta) \cdot \sum_{i=0}^{h} (-1)^i \cdot a_i \cdot Q_i \cdot \left[(\cos\theta)^2\right]$$

$$Gy = (\sin\theta) \cdot \sum_{i=0}^{h} b_i \cdot Q_i \cdot \left[(\sin\theta)^2\right]$$

- then eliminating the first h derivatives of the respective relative gains $G_x$, $G_y$, about the centre value $\cos\theta$ and about the centre value $\sin\theta$ for $\theta = \pi\frac{F_c}{F_e}$, approximating $\cos^2\theta$ by means of a rational fraction;
- then using a standard algorithm to solve the system of 2h integer coefficient linear equations thus obtained; the solving of this system supplying respective coefficient values $a_0$, ..., $a_h$ and $b_0$, ..., $b_h$ as a function of $a_0$ and $b_0$, respectively, in rational form;
- multiplying by the same integer factor all the coefficients $a_1$, ..., $a_h$ and $b_1$, ..., $b_h$, respectively, to obtain them in an integer form dependent on $a_0$, $b_0$, respectively;
- calculating the value of $a_0$, $b_0$, respectively, such that the relative gains $G_x$ and $G_y$ are approximately equal for $\theta = \pi\frac{F_c}{F_e}$ with a given accuracy dependent on the application of the digitiser.

2. Analytical digitiser for signal processing comprising:

- means (1 to 3) for sampling an analogue signal to be processed and for converting the analogue value of each sample into a digital value;
- first calculating means (4 to 8, 11 to 19) supplying a sequence of digital values x(t) each calculated by adding 2h+2 values supplied by the digitising means weighted by respective non-null integer coefficients $a_0$, ..., $a_h$, $a_h$ ..., $a_0$;
- second calculating means (4 to 8, 21 to 29) supplying a sequence of digital values y(t) each calculated by adding $\underline{h}$ values supplied by the digitising means weighted by respective non-null integer coefficients $b_0$, ..., $b_h$, $-b_h$, ..., $-b_0$;
- means (31) for supplying to said first and second calculating means the values of the coefficients $a_0$, ..., $a_h$, $b_0$, ..., $b_h$;

characterised in that the number h+1 of coefficients $a_0$, ..., $a_h$, $b_0$, ..., $b_h$, respectively, and their value vary according to the centre frequency $F_c$ of the signal and the bandwidth B of the spectrum of the signal to be processed; and in that the means (31) for supplying the values of the coefficients $a_0$, ..., $a_h$, $b_0$, ..., ..., $b_h$ include:

- means (51) for incrementing the number h, starting from h = 1, the number $\underline{h}$ being incremented subsequently under the control of an incrementing signal;
- means (52) for replacing the trigonometrical lines $\cos(2i+1)\theta$ and $\sin(2i+1)\theta$ for i = 0, ..., h with their respective standard polynomial expression in the form:

$$\begin{cases} \cos(2i+1)\theta = (-1)^i (\cos\theta) \cdot Q_i \left[(\cos\theta)^2\right] \\ \\ \sin(2i+1)\theta = (\sin\theta) \cdot Q_i \left[(\sin\theta)^2\right] \end{cases}$$

where $Q_i$ is a standard ith degree polynomial, in the following polynomials:

$$\begin{cases} Gx = a_0\cos\theta + a_1\cos3\theta + ... + a_i\cos(2i+1)\theta + ... + a_h\cos(2h+1)\theta \\ Gy = b_0\sin\theta + b_1\sin3\theta + ... + b_i\sin(2i+1)\theta + ... + b_h\sin(2h+1)\theta \end{cases}$$

to obtain two polynomials which are the relative gains of the first and second calculating means and which are in the form:

$$Gx = (\text{Cos}\theta) . \sum_{i=0}^{h} (-1)^{i} . a_i . Q_i . \left[(\text{Cos}\theta)^2\right]$$

$$Gy = (\text{Sin}\theta) \sum_{i=0}^{h} b_i . Q_i \left[(\text{Sin}\theta)^2\right]$$

- means (53) for eliminating the first $\underline{h}$ derivatives of the respective relative gains $G_x$, $G_y$, about the centre value $\cos\theta$ and about the centre value $\sin\theta$ for $\theta = \pi\frac{F_c}{F_e}$, approximating $\cos^2\theta$ by means of a rational fraction;
- means (54) for using a standard algorithm to solve the system of 2h integer coefficient linear equations thus obtained; the solving of this system supplying respective coefficient values $a_1$, ..., $a_h$ and $b_1$, ..., $b_h$ as a function of $a_0$ and $b_0$, respectively, in rational form;
- means (55) for multiplying by the same integer factor all the coefficients $a_1$, ..., $a_h$ and $b_1$, ..., $b_h$, respectively, to obtain them in an integer form dependent on $a_0$, $b_0$, respectively;
- means (56) for calculating the value of $a_0$, $b_0$ respectively, such that the relative gains $G_x$ and $G_y$ of the first and second calculating means (4 to 8, 11 to 19 and 4 to 8, 21 to 29) are approximately equal for $\theta = \pi\frac{F_c}{F_e}$;
- means (57) for calculating an estimate of the quadrature signal/noise ratio equal to:

$$\frac{S}{N} = 4\left[\frac{G_y^2 + G_x^2}{G_y^2 - G_x^2}\right]^2$$

- means (58) for comparing this ratio to a predetermined limit value defining the minimal tolerable quadrature/ signal noise ratio; said means supplying an incrementing signal to the means (51) for incrementing the number $\underline{h}$ if the value of the ratio is less than the limit value or supplying a signal validating the current value of $\underline{h}$ and the coefficient values just determined if the value of said ratio is greater than or equal to the limit value.

3. Digitiser according to claim 2 characterised in that the first calculating means further comprise:

- means (41) for estimating the zero error over a series of values of x(t) of the first component and supplying a correction signal having a value c(t);
- means for adding the value c(t) of the correction signal to each value of x(t) calculated by the first calculating means.

4. Digitiser according to claim 2 characterised in that each of the first and second calculating means further include means (42, 43) for reducing the number of bits of a first binary word representing the absolute value of x(t), y(t), respectively, said means (42, 43) including means for:

- forming a second binary word by truncating $\underline{b}$ least significant bits from the first binary word where $\underline{b}$ is a fixed number;
- forming a third binary word by truncating $\underline{b}$ least significant bits from the first binary word and then incrementing its value by unity;
- comparing the value x(t), y(t), respectively, with the values of the second and third binary words;
- representing the value of x(t), y(t), respectively, by whichever has the value nearer the value of the first binary word.

**5.** Digitiser according to claim 2 characterised in that to increase the dynamic range of the digitiser the first and second calculating means further include means (44) for:

- calculating the amplitude of the spectral components of the signal to be treated from the values x(t), y(t) determined by the first and second calculating means (39);
- determining which of these components has the highest amplitude;
- eliminating the component symmetrical to said highest amplitude component about the centre frequency $F_c$ of the signal;
- determining a new, as yet unprocessed component of greatest amplitude;
- eliminating the component symmetrical to said new component about the centre frequency $F_c$ of the signal;
- reiterating this process until all components of amplitude greater than a fixed value have been processed.

**6.** Digitiser according to claim 2 wherein the first and second calculating means further include means (45) for converting each pair of values x(t), y(t) into two polar co-ordinates $\rho$ and $\theta$;
characterised in that, to calculate $\theta$, said converter means include means for:

- retaining only $\underline{s}$ absolute value bits and one sign bit for the value x(t), y(t), respectively, $\underline{s}$ being a fixed number, the $\underline{s}$ bits retained having the same rank in the value of x(t) and in the value of y(t), and the bits not retained being in all cases the least significant bits;
- concatenating these 2s bits to constitute an address;

and include a read-only memory containing $2^{2s}$ approximate values of $\theta$ addressed by means of said address to read therein a value $\theta$ for each pair of values x(t), y(t).

**7.** Digitiser according to claim 2 characterised in that the calculating rate $F_e$ and the centre frequency $F_c$ of the signal received are related by the equation $\frac{F_c}{F_e} = \pm\frac{1}{4} + k$ where $\underline{k}$ is a positive integer or zero.

FIG.1

$\underline{39}$

31

$a_0 \ldots a_{h-1}$

11 $+$

10 $r(t)$

1

2

3

12 $+$

13 $+$

4 5 6 7 8 9

21 $-$

22 $-$

23 $-$

x$a_h$ 14

17 $+$

x$a_{h-1}$ 15

18 $+$

x$a_{h-2}$ 16

19 $+$ x(t) 20

$b_0 \ldots b_{h-1}$

29 $+$ y(t) 30

x$b_{h-2}$ 24

28 $+$

x$b_{h-1}$ 25

26 x$b_h$ 27 $+$

28

EP 0 632 589 B1

# FIG.2

# FIG.3

EP 0 632 589 B1

40

41 c(t)

20

10

r(t)

30

x(t)

30

y(t)

+

x'(t)

42

xa(t)

43

ya(t)

44

xc(t)

yc(t)

45

46

θ(t)

47

ρ(t)

# FIG.4

yc

63

15

1

θ

0 1    15    63    xc